(19) Europäisches Patentamt
European Patent Office
Office européen des brevets

(11) **EP 4 568 446 A1**

(12) **EUROPEAN PATENT APPLICATION**

(43) Date of publication:
**11.06.2025 Bulletin 2025/24**

(21) Application number: **24217417.5**

(22) Date of filing: **04.12.2024**

(51) International Patent Classification (IPC):
*H10B 51/10* (2023.01)   *H10B 51/20* (2023.01)
*H10B 51/30* (2023.01)   *H10D 30/01* (2025.01)
*H10D 30/69* (2025.01)   *H10D 64/01* (2025.01)
*H10D 64/68* (2025.01)

(52) Cooperative Patent Classification (CPC):
**H10B 51/30; H10B 51/10; H10B 51/20;
H10D 30/0415; H10D 30/701; H10D 64/033;
H10D 64/689**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **05.12.2023 KR 20230174830**

(71) Applicant: Samsung Electronics Co., Ltd.
Suwon-si, Gyeonggi-do 16677 (KR)

(72) Inventors:
• **KIM, Donghoon**
  **16678 Suwon-si (KR)**
• **NAM, Seunggeol**
  **16678 Suwon-si (KR)**
• **YOO, Sijung**
  **16678 Suwon-si (KR)**
• **LEE, Hyunjae**
  **16678 Suwon-si (KR)**

(74) Representative: **Elkington and Fife LLP**
**Prospect House**
**8 Pembroke Road**
**Sevenoaks, Kent TN13 1XR (GB)**

(54) **SEMICONDUCTOR DEVICE AND ELECTRONIC DEVICE INCLUDING THE SAME**

(57)     A semiconductor device (100) includes a channel layer (111) including a semiconductor material, a gate electrode (170), a ferroelectric layer (140) between the channel layer and the gate electrode, a first insulating layer (160) between the ferroelectric layer and the gate electrode, a charge trap layer (150) between the ferroelectric layer and the first insulating layer and including a first element, and a second insulating layer (130) between the channel layer and the ferroelectric layer, wherein the charge trap layer (150) includes a first layer (151), a second layer (152), and a third layer (153), and a highest value in a concentration gradient in the first layer is a first concentration value (CG1), a lowest value in a concentration gradient in the second layer is a second concentration value (CG2), and a highest value in a concentration gradient in the third layer is a third concentration value (CG3), the second concentration value is lower than the first concentration value and the third concentration value.

FIG. 1

EP 4 568 446 A1

## Description

FIELD OF THE INVENTION

The disclosure relates to a semiconductor device and an electronic device including the same.

BACKGROUND OF THE INVENTION

Ferroelectrics are materials with ferroelectricity that maintain spontaneous polarization by aligning internal dipole moments even when no electric field is applied thereto from the outside. Even if a certain voltage is applied to ferroelectrics and the voltage is brought back to 0 V, the polarization in the ferroelectrics remains semi-permanently. Research on applying such ferroelectric characteristics to logic devices or memory devices is continuing. For example, in the case of a ferroelectric field-effect transistor including a ferroelectric, the threshold voltage of the ferroelectric field-effect transistor may vary with the polarization direction within the ferroelectric. A logic device or a memory device may be implemented by using the threshold voltage change characteristics of the ferroelectric field-effect transistor.

SUMMARY OF THE INVENTION

Provided are a semiconductor device and an electronic device including the same.

Additional aspects will be set forth in part in the description which follows and, in part, will be apparent from the description, or may be learned by practice of the presented embodiments.

According to an aspect of the disclosure, a semiconductor device includes a channel layer comprising a semiconductor material; a gate electrode spaced apart from the channel layer in a first direction; a ferroelectric layer between the channel layer and the gate electrode, the ferroelectric layer comprising a ferroelectric material; a first insulating layer between the ferroelectric layer and the gate electrode; a charge trap layer between the ferroelectric layer and the first insulating layer, the charge trap layer comprising a compound including a first element; and a second insulating layer between the channel layer and the ferroelectric layer, wherein the charge trap layer comprises a third layer, a second layer, and a first layer, sequentially stacked in the first direction, and each of the first layer, the second layer, and the third layer have a different concentration of the first element, and wherein a highest value in a concentration gradient in the first layer is a first concentration value, a lowest value in a concentration gradient in the second layer is a second concentration value, a highest value in a concentration gradient in the third layer is a third concentration value, and the second concentration value is lower than the first concentration value and the third concentration value.

The first concentration value may be higher than the third concentration value.

The thickness of the second layer may be 50% or more of a total thickness of the charge trap layer.

In the concentration gradient of the second layer, the length in the first direction of an area having a concentration lower than the third concentration value may be 60% or more of the thickness of the second layer.

The thickness of the second layer may be greater than a thickness of the first layer and a thickness of the third layer.

The thickness of the third layer may be 1% or more of a total thickness of the charge trap layer.

The thickness of the third layer may be greater than the thickness of the first layer.

The charge trap layer may further include nitrogen.

The first layer, the second layer, and the third layer may each independently include a compound represented by MN, in which M denotes the first element and includes one or more elements selected from the group consisting of Al, Ga, Ge, Si, C, In, Y, Sc, and Zr, and N denotes nitrogen.

The first layer, the second layer, and the third layer may each independently include the nitride of the first element, in which a nitrogen content may be less than stoichiometry.

The first layer, the second layer, and the third layer may each independently include $Si_3N_{4-x}$, where $0<x\leq2$.

The second insulating layer may include an oxide of a material of the channel layer.

The ferroelectric material of the ferroelectric layer may include a hafnium oxide-based material.

The ferroelectric material may further include at least one of Zr, La, Al, Si, Y, B, or Sc as a dopant.

The first element may include one or more elements selected from the group consisting of Al, Ga, Ge, Si, C, in, Y, Sc, and Zr.

According to another aspect of the disclosure, a semiconductor device includes a channel layer comprising a semiconductor material; a gate electrode spaced apart from the channel layer in a first direction; a ferroelectric layer between the channel layer and the gate electrode, the ferroelectric layer including a ferroelectric material; a first insulating layer between the ferroelectric layer and the gate electrode; a charge trap layer between the ferroelectric layer and the first insulating layer, the charge trap layer comprising a silicon nitride; and a second insulating layer between the channel layer and the ferroelectric layer, wherein the charge trap layer comprises a third layer, a second layer, and a first layer

sequentially stacked in the first direction, and each of the first layer, the second layer, and the third layer have a different concentration such that a concentration of silicon in the charge trap layer is lowest in the second layer, and highest in the first layer.

The first layer, the second layer, and the third layer may each independently include $Si_3N_{4-x}$, where $0<x\leq2$.

According to another aspect of the disclosure, an electronic device includes a semiconductor substrate, and a plurality of memory cells stacked on the semiconductor substrate, wherein each of the plurality of memory cells may include a channel layer comprising a semiconductor material, a gate electrode spaced apart from the channel layer in a first direction, a ferroelectric layer between the channel layer and the gate electrode, the ferroelectric layer comprising a ferroelectric material, a first insulating layer between the ferroelectric layer and the gate electrode, a charge trap layer between the ferroelectric layer and the first insulating layer, the charge trap layer comprising a compound including a first element, and a second insulating layer between the channel layer and the ferroelectric layer, wherein the charge trap layer comprises a third layer, a second layer, and a first layer, sequentially stacked in the first direction, and each of the first layer, the second layer, and the third layer have a different concentration of the first element, wherein a highest value in a concentration gradient in the first layer is a first concentration value, a lowest value in a concentration gradient in the second layer is a second concentration value, a highest value in a concentration gradient in the third layer is a third concentration value, and the second concentration value is lower than the first concentration value and the third concentration value, and wherein the first direction is perpendicular to a stack direction of the plurality of memory cells.

A spacer, including an insulating material, may be further included such that the spacer is between adjacent gate electrodes.

The adjacent gate electrodes and the spacer may have a shell shape with connected inner surfaces.

BRIEF DESCRIPTION OF THE DRAWINGS

These and/or other aspects will become apparent and more readily appreciated from the following description of the embodiments, taken in conjunction with the accompanying drawings in which:

FIG. 1 is a cross-sectional view of a schematic structure of a semiconductor device according to at least one embodiment;

FIG. 2 is a conceptual diagram for describing a multilayer structure of a charge trap layer provided in the semiconductor device of FIG. 1 and a concentration distribution of each layer;

FIG. 3 is a graph showing a concept of a memory window indicated by a semiconductor device according to at least one embodiment;

FIG. 4A is a conceptual view illustrating an electric charge distribution in a semiconductor device according to at least one embodiment when the semiconductor device is in a program state;

FIG. 4B illustrates an example of an electric charge density in a semiconductor device according to at least one embodiment when the semiconductor device is in the program state;

FIG. 5A is a conceptual view illustrating an electric charge distribution in a semiconductor device according to at least one embodiment when the semiconductor device is in an erase state;

FIG. 5B illustrates an example of an electric charge density in a semiconductor device according to at least one embodiment when the semiconductor device is in the erase state;

FIG. 6 is a cross-sectional view of a schematic structure of a semiconductor device according to a comparative example;

FIGS. 7A and 7B illustrate examples of an electric charge density in a semiconductor device according to a comparative example when the semiconductor device is in a program state and an erase state;

FIG. 8A is a cross-sectional view showing a schematic structure of a memory device according to at least one embodiment, and FIG. 8B is a cross-sectional view of the memory device of FIG. 8A taken along line A-A';

FIG. 9 is an equivalent circuit of a memory device according to at least one embodiment;

FIG. 10 is a schematic circuit diagram of a neural network device according to at least one embodiment; and

FIG. 11 is a schematic block diagram of an electronic device including a neural network device according to at least one embodiment.

DETAILED DESCRIPTION

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments are described in detail with reference to the accompanying drawings. Embodiments described below are just examples, and various modifications are available from the embodiments. Throughout the drawings, like reference numerals denote like elements, and sizes of components in the drawings may be exaggerated for convenience of explanation and clarity.

Hereinbelow, when a constituent element is disposed "above" or "on" to another constituent element, the constituent element may be only directly on the other constituent element or above the other constituent elements in a non-contact manner. Additionally, it will be understood that spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly.

It will be understood that although the terms "first," "second," etc. may be used herein to describe various components, these components should not be limited by these terms. These terms are only used to distinguish one component from another. These terms do not limit that the materials or structures of components are different from each other.

As used herein, the singular forms "a," "an," and "the" are intended to include the plural forms as well, unless the context clearly indicates otherwise. It will be further understood that the terms "comprises" and/or "comprising" used herein specify the presence of stated features or components, but do not preclude the presence or addition of one or more other features or components.

Furthermore, terms such as "... portion," "... unit," "... module," and "... block" stated in the specification may signify a unit to process at least one function or operation and the unit may be embodied by and/or implemented by processing circuitry, such as hardware, software, or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc., and/or electronic circuits including said components.

The use of the terms "a," "an," "the," and similar referents in the context of describing the disclosure are to be construed to cover both the singular and the plural. Additionally, whenever a range of values is enumerated, the range includes all values within the range as if recorded explicitly clearly, and may further include the boundaries of the range. Accordingly, the range of "X" to "Y" includes all values between X and Y, including X and Y. Further, when the terms "about" and/or "substantially" are used in this specification in connection with a numerical value and/or geometric terms, it is intended that the associated numerical value includes a manufacturing tolerance (e.g., $\pm 10\%$) around the stated numerical value. Further, regardless of whether numerical values and/or geometric terms are modified as "about" or substantially," it will be understood that these values should be construed as including a manufacturing or operational tolerance (e.g., $\pm 10\%$) around the stated numerical values and/or geometry.

The operations of all methods described herein can be performed in any suitable order unless otherwise indicated herein or otherwise clearly contradicted by context. Furthermore, the use of any and all examples, or language (e.g., "such as") provided herein, is intended merely to better illuminate the disclosure and does not pose a limitation on the scope of the disclosure unless otherwise claimed.

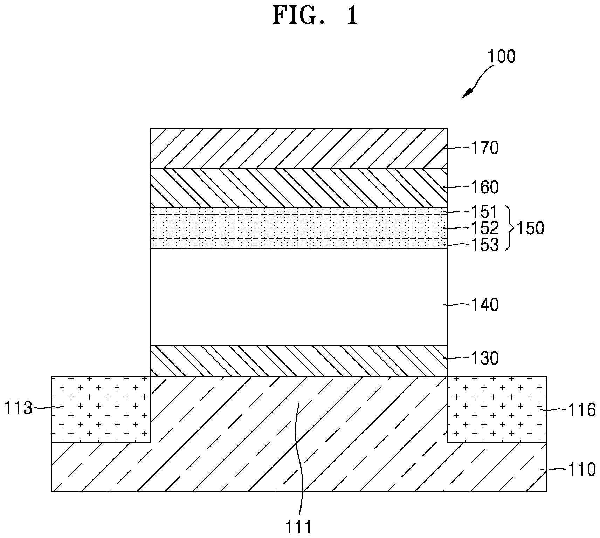

FIG. 1 is a cross-sectional view of a schematic structure of a semiconductor device 100 according to at least one embodiment.

The semiconductor device 100 may include a channel layer 111 including a semiconductor material, a ferroelectric layer 140 disposed above the channel layer 111 and including a ferroelectric material, a gate electrode 170 disposed above the ferroelectric layer 140, a first insulating layer 160 disposed between the ferroelectric layer 140 and the gate electrode 170, a charge trap layer 150 disposed between the ferroelectric layer 140 and the first insulating layer 160, and a second insulating layer 130 disposed between the channel layer 111 and the ferroelectric layer 140.

The semiconductor device 100 according to at least one embodiment may include a charge trap layer 150 having multiple types of stoichiometries for memory window expansion. For example, the charge trap layer 150 may include a compound including a first element, and the concentration of the first element within the charge trap layer 150 may vary according to a position within the charge trap layer 150. In at least one embodiment, for example, the charge trap layer 150 may include multiple layers having different concentration gradient characteristics of the first element, and may include, for example, a third layer 153, a second layer 152, and a first layer 151, disposed on the ferroelectric layer 140. In other words, the concentrations of the first element in the first layer 151, the second layer 152, and the third layer 153 may differ from one another along a stack direction. In at least one embodiment, interfaces between the third layer 153, the second layer 152, and the first layer 151 may be visibly indistinct.

The charge trap layer 150 may include one or more nitrides. The charge trap layer 150 may include, for example, a nitride of the first element. The charge trap layer 150 may include, for example, a material that can implement a charge trap that is 1 eV or more less than the conduction band of the material. In at least one embodiments, the first layer 151, the second layer 152, and the third layer 153 may each independently include a compound represented by MN, where M denotes an element including one or more elements selected from the group consisting of Al, Ga, Ge, Si, C, in, Y, Sc, and Zr and N denotes nitrogen. The charge trap layer 150 may include, for example, at least one of AlN, GaN, GeN, SiN, CN, InN, YN, ScN, or ZrN. For example, when the charge trap layer 150 includes a silicon nitride, the first element may be Si. This is merely an example, and in order to make the trap level of the second layer 152 the deepest among the first layer 151, the second layer 152, and the third layer 153, in each layer, the concentration gradient of the first element, which is an element included in a compound forming the charge trap layer 150, may be differently set. Therefore, a ratio of M and N may vary based on position in the charge trap layer 150.

For example, the first layer 151, the second layer 152, and the third layer 153 may each independently include a nitride of the first element, in which a nitrogen content is less than the stoichiometry. The first layer 151, the second layer 152, and the third layer 153 may each independently include $Si_3N_{4-x}$ ($0<x\leq2$).

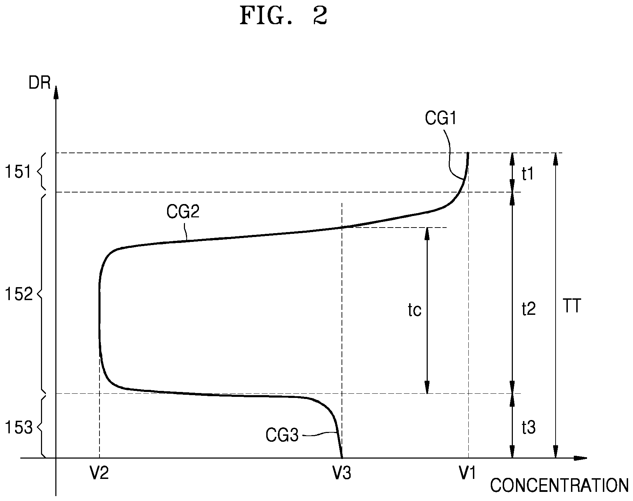

The specific structure of the charge trap layer 150 and the concept that the memory window is expanded by the charge trap layer 150 are described below in detail with reference to FIG. 2.

The semiconductor device 100 is a field effect transistor that exhibits a different threshold voltage according to the voltage applied to the gate electrode 170.

The channel layer 111 may be included in a substrate 110 including the semiconductor material. For example, the channel layer 111 may be defined as an area between a source region 113 and a drain region 116 that are spaced apart from each other in the substrate 110 including the semiconductor material and/or as an area between the source region 113 and the drain region 116 on the substrate 110 on which the source region 113 and the drain region 116 are formed.

In at least one embodiment, the source region 113 and the drain region 116 may be doped with a first conductivity type, and the substrate 110 may be doped with a second conductivity type electrically opposite to the first conductivity type. For example, the substrate 110 may include a p-type semiconductor and the source region 113 and the drain region 116 may include an n-type semiconductor, or the substrate 110 may include an n-type semiconductor and the source region 113 and the drain region 116 may include a p-type semiconductor. The substrate 110 may be doped at relatively low concentration of about $10^{16}$/cm$^3$ to $10^{17}$/cm$^3$, whereas the source region 113 and the drain region 116 may be doped at a relatively high concentration of about $10^{19}$/cm$^3$ to $10^{21}$/cm$^3$ for low resistance. The source region 113 and the drain region 116 may be formed by respectively doping the opposite sides of an upper portion of the substrate 110. An upper area of the substrate 110 where the source region 113 and the drain region 116 are not formed may become the channel layer 111.

The channel layer 111 may include an elemental (e.g., group IV) semiconductor, a compound semiconductor, a two-dimensional semiconductor, and/or an oxide semiconductor. The channel layer 111 may include, for example, Si, Ge, SiGe, $MoS_2$, $WSe_2$, graphene, indium gallium zinc oxide (IGZO), tungsten doped indium oxide (IWO), and/or ZnSnO. In addition, the channel layer 111 may include a group III-V compound semiconductor, a group II-VI compound semiconductor, and/or the like. Additionally, in at least some embodiments, the channel layer 111 may be (and/or include) a semiconductor material deposited on the substrate 110.

The substrate 110, the source region 113, and the drain region 116 may include the same base material described above with respect to the channel layer 111.

When the substrate 110, the channel layer 111, the source region 113, and the drain region 116 include Si, Ge, SiGe, and/or the like, the substrate 110 and the channel layer 111 may each be doped with a dopant of at least one of boron (B), Al, Ga, and In, and the source region 113 and the drain region 116 may each be doped with a dopant of at least one of phosphorus (P), arsenic (As), and antimony (Sb). In these cases, the semiconductor device 100 may be referred to as an n-channel metal oxide semiconductor field effect transistor (NMOS). Alternatively, reversely, the substrate 110 and the channel layer 111 may each be doped with a dopant of at least one of P, As, and Sb, and the source region 113 and the drain region 116 may each be doped with a dopant of at least one of B, Al, Ga, and In. In these cases, the semiconductor device 100 may be referred to as a p-channel metal oxide semiconductor field effect transistor (PMOS).

The ferroelectric layer 140 may include a ferroelectric material. A ferroelectric material is a material having ferroelectricity in which spontaneous polarization is maintained as internal dipole moments are aligned even without maintaining an externally applied electric field thereto. A threshold voltage of the semiconductor device 100 may vary according as the polarization direction of the ferroelectric layer 140 is, for example, a direction from the gate electrode 170 to the channel layer 111 or reversely a direction from the channel layer 111 to the gate electrode 170.

In at least some embodiments, the ferroelectric material included in the ferroelectric layer 140 may include a hafnium oxide material or an aluminum nitride material. The ferroelectric material may have a structure in which a dopant is inserted in a hafnium oxide-based material or a structure in which a dopant is inserted in an aluminum nitride-based material. When a ferroelectric material included in the ferroelectric layer 140 is a hafnium oxide-based material, a dopant may include Zr, lanthanum (La), Al, Si, or Y. When a ferroelectric material included in the ferroelectric layer 140 is an aluminum nitride-based material, a dopant may include B or Sc.

The ferroelectric layer 140 may include an orthorhombic crystalline phase and/or a tetragonal crystalline phase. In some cases, the ferroelectric layer 140 may include the orthorhombic crystalline phase more than the tetragonal crystalline phase. The crystalline phase distribution may be confirmed by, for example, transmission electron microscopy (TEM), grazing incidence X-ray diffraction (GIXRD), and/or the like.

In addition, the ferroelectric layer 140 may include, for example, a ferroelectric material having at least one of a fluorite structure, a perovskite structure, and a wurtzite structure. A ferroelectric material having a fluorite structure may include, for example, a hafnium oxide $HfO_2$. A hafnium oxide may be doped with at least one element of, for example, Zr, La, Al, Si, Y, gadolinium (Gd), and/or the like. The ferroelectric layer 140 may also include a semi-ferroelectric material. For example, the semi-ferroelectric material may include a zirconium oxide. The zirconium oxide may be doped with at least one element of, for example, hafnium (Hf), La, Al, Si, Y, and Gd. A ferroelectric material having a perovskite structure may include, for example, lead zirconate titanate (PZT). A ferroelectric material having a wurtzite structure may include, for example, a zinc oxide (ZnO) or an aluminum nitride (AlN). The ferroelectric material having a wurtzite structure may be doped with at least one element of, for example, B and Sc. Furthermore, the ferroelectric layer 140 may include not only the ferroelectric material described above, but also a semi-ferroelectric material. For example, the ferroelectric layer 140 may include $ZrO_2$.

In at least one embodiment, the ferroelectric layer 140 may include at least one of Hf and Zr. The ferroelectric layer 140 may include Hf and Zr at the same (and/or substantially similar) ratio (e.g., $Hf_{0.5}Zr_{0.5}O_2$), and additionally, may be doped with at least one element of La, Al, Si, Y, and/or Gd at a ratio of less than 10 at%.

The thickness of the ferroelectric layer 140 may be, for example, about 5 nm to about 20 nm. However, the disclosure is not limited thereto.

The gate electrode 170 may include one or more conductive materials selected from, e.g., the group consisting of metal, metal nitride, metal carbide, polysilicon, and/or a combination thereof. For example, the metal may include Al, tungsten (W), molybdenum (Mo), titanium (Ti), or tantalum (Ta), a metal nitride film may include a titanium nitride film (TiN film) or a tantalum nitride film (TaN film), and the metal carbide may include aluminum- or silicon-doped (or contained) metal carbide and as a detailed example, may include TiAlC, TaAlC, TiSiC, or TaSiC. The gate electrode 170 may have a stacked structure of a plurality of materials. For example, the gate electrode 170 may have a stack structure of a metal nitride layer / a metal layer, such as TiN/Al and/or the like, or a stack structure of a metal nitride layer / a metal carbide layer / a metal layer, such as TiN/TiAlC/W. The gate electrode 170 may include a titanium nitride (TiN) film or Mo, and the example presented above may be used in variously modified forms. Furthermore, the gate electrode 170 may include a conductive two-dimensional material in addition to the material described above. For example, the conductive two-dimensional material may include at least one of graphene, black phosphorus, amorphous boron nitride, two-dimensional hexagonal nitride boron (h-BN), and phosphorene.

The first insulating layer 160 disposed between the charge trap layer 150 and the gate electrode 170 may include one or more insulating materials. The first insulating layer 160 may include, for example, $SiO_2$, $Al_2O_3$, $MgO_2$, or AlN. When a sufficiently high voltage (e.g., a write voltage or an erase voltage) is applied to the gate electrode 170, the first insulating layer 160 may transmit electric charges from the gate electrode 170 to the charge trap layer 150 through a tunnel effect. When no voltage or a low voltage (e.g., a standby voltage or a read voltage) is applied to the gate electrode 170, the first insulating layer 160 may prevent the electric charges captured at the interface of the ferroelectric layer 140 from being leaked through the gate electrode 170. The first insulating layer 160 may be referred to as a tunnel barrier layer.

The first insulating layer 160, with the charge trap layer 150, may contribute to memory window expansion. For example, capacitance occurring between the gate electrode 170 and the ferroelectric layer 140 may be reduced by the first insulating layer 160, and thus, a memory window may expand. The thickness of the first insulating layer 160 may be about 1 nm or more, about 5 nm or less, or about 3 nm or less. For example, the thickness of the first insulating layer 160 may be within an inclusive range of 1 nm to 5 nm and/or 1 nm to 3 nm; however, this is an example, but the disclosure is not limited thereto.

The second insulating layer 130 disposed between the channel layer 111 and the ferroelectric layer 140 may include various insulating materials. The second insulating layer 130 may include an oxide of the material included in the channel layer 111. For example, when the channel layer 111 includes Si, the second insulating layer 130 may include $SiO_2$. When the channel layer 111 includes Ge, the second insulating layer 130 may include $GeO_2$. When the channel layer 111 includes SiGe, the second insulating layer 130 may include $SiGeO_4$. The second insulating layer 130 may be formed as a portion of a semiconductor material included in the channel layer 111 is naturally oxidized as above. Alternatively, an additional deposition process and/or the like may be further performed depending on the thickness required for the second insulating layer 130. The second insulating layer 130 may include a plurality of layers.

FIG. 2 is a conceptual diagram for describing a multilayer structure of the charge trap layer 150 provided in the semiconductor device 100 of FIG. 1 and a concentration distribution of each layer.

The first element included in the compound forming the charge trap layer 150 may have a certain concentration gradient within the first layer 151, the second layer 152, and the third layer 153. As illustrated in FIG. 2, the first layer 151, the second layer 152, and the third layer 153 may exhibit a first concentration gradient CG1, a second concentration gradient CG2, and a third concentration gradient CG3, respectively, according to a thickness direction DR thereof. The charge trap layer 150 may include a silicon nitride, and the first element may include Si. However, the disclosure is not limited thereto.

When the highest value of the first concentration gradient CG1 occurring in the first layer 151 is a first concentration value V1, the lowest value of the second concentration gradient CG2 occurring in the second layer 152 is a second concentration value V2, and the highest value of the third concentration gradient CG3 occurring in the third layer 153 is a third concentration value V3, the second concentration value V2 may be less than the first concentration value V1 and the third concentration value V3. The first concentration value V1 may be greater than the third concentration value V3. In other words, the first concentration value V1 (e.g., representing an atomic ratio of Si to N in the first layer 151), may be greater than the second concentration value V2 (representing an atomic ratio of Si to N in the second layer 152), and/or the third concentration value V3 (representing an atomic ratio of Si to N in the third layer 153).

The second layer 152 is a layer forming a deep trap, and may, therefore, have a trap level deeper than those of the first layer 151 and the third layer 153. To form the deep trap, the second concentration gradient CG2 occurring in the second layer 152 may have a shape in which the concentration of the first element decreases and then increases along a first direction DR. The thickness direction DR may be a stack direction in which the third layer 153, the second layer 152, and the first layer 151 are stacked on the ferroelectric layer 140. The term "stack direction" may be interchangeably used with the "thickness direction" and/or a "first direction". As illustrated in the drawings, the second concentration gradient CG2 of the second layer 152 may have a shape in which the concentration of the first element sharply decreases, maintains a low concentration, and then sharply increases, along the thickness direction DR. The illustrated specific shape is an example, and the disclosure is not limited thereto. The electric charges stored in the deep trap of the second layer 152 do not escape well, which may substantially contribute to the memory window expansion.

The first layer 151 is a layer forming a shallow trap, and may serve to capture the electric charges from the gate electrode 170 into the deep trap of the second layer 152. A thickness t1 of the first layer 151 may be defined as a range indicating a concentration ranged from the first concentration value V1 that is the maximum value of the first concentration gradient CG1 to a 90% of the first concentration value V1.

The third layer 153 may indicate an intermediate level between the first layer 151 and the second layer 152, that is, a trap level deeper than the first layer 151 and shallower than the second layer 152. The third layer 153 may serve as a reservoir that supplements the electric charges escaped from the deep trap of the second layer 152. A boundary between the third layer 153 and the second layer 152 may be defined as a position of an inflection point that occurs first in the thickness direction DR in the concentration gradient including the third concentration gradient CG3 and the second concentration gradient CG2. Based on the above definition, a thickness t3 of the third layer 153 may be defined.

A thickness t2 of the second layer 152 may be 50% or more of a total thickness TT of the charge trap layer 150. Alternatively, the thickness t2 of the second layer 152 may be 40% or more, 60% or more, and/or 70% or more of TT. The thickness t2 of the second layer 152 may be greater than both the thickness t3 of the third layer 153 and/or the thickness t1 of the first layer 151.

The thickness of an area indicting a concentration lower than the third concentration value V3 in the second concentration gradient CG2 of the second layer 152 (the length tc in the thickness direction DR) may be 60% or more, 50% or more, 70% or more, and/or 80% or more of the thickness t2 of the second layer 152.

The thickness t3 of the third layer 153 may be greater than the thickness t1 of the first layer 151. The thickness t3 of the third layer 153 may be, for example, 105% or more, or 110%, or 120% or more of the thickness t1 of the first layer 151.

The thickness t3 of the third layer 153 may be 5% or more of the total thickness TT of the charge trap layer 150, and the thickness t1 of the first layer 151 may be less than 5% of the total thickness TT of the charge trap layer 150 and greater than 0. Alternatively, the thickness t3 of the third layer 153 may be 10% or more of the total thickness TT of the charge trap layer 150, and the thickness t1 of the first layer 151 may be less than 10% of the total thickness TT of the charge trap layer 150 and greater than 0. Alternatively, the thickness t3 of the third layer 153 and the thickness t1 of the first layer 151 may each be 25% or less of the total thickness TT of the charge trap layer 150, and the thickness t3 of the third layer 153 may be greater than the thickness t1 of the first layer 151.

Alternatively, the thickness of the first layer 151 may be 1% or more, 2% or more, or 3% or more of the total thickness TT of the charge trap layer 150. The thickness of the third layer 153 may be 1% or more, 2% or more, or 3% or more of the total thickness TT of the charge trap layer 150.

The first layer 151, the second layer 152, and the third layer 153, having different concentration gradient of the first element can be manufactured by controlling the atomic layer deposition(ALD) cycle. For example, when forming a SiN layer, Si 1-cycle and N 1-cycle can be alternately repeated. For example, the first layer 151 and the third layer 153, each can be formed by performing Si 2-cycle and N 1-cycle, and the second layer 152 can be formed by performing Si 1-cycle and N 2-cycle. The number of cycles can be controlled depending on the concentration difference between the first layer 151, second layer 152, and third layer 153.

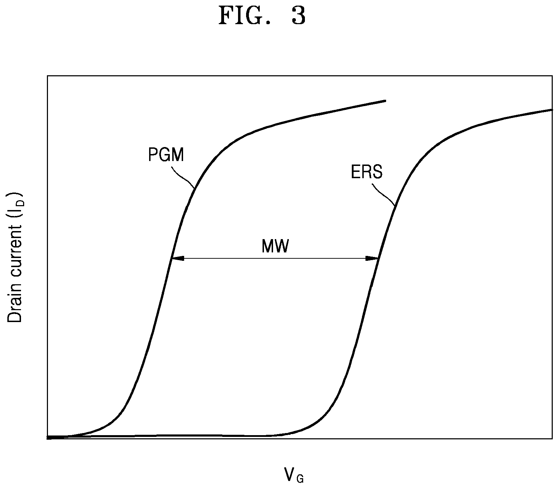

FIG. 3 is a graph conceptually describing a memory window indicated by a semiconductor device according to at least one embodiment.

Two graphs indicated by program PGM and erase ERS show drain currents to a gate voltage VG in a program state and an erase state. A memory window MW is a difference between two different threshold voltages of the semiconductor device 100. As the memory window MW increases, the operation reliability of the semiconductor device 100 may be improved. For example, the memory window MW of the semiconductor device 100 may be about 6.5 V or more.

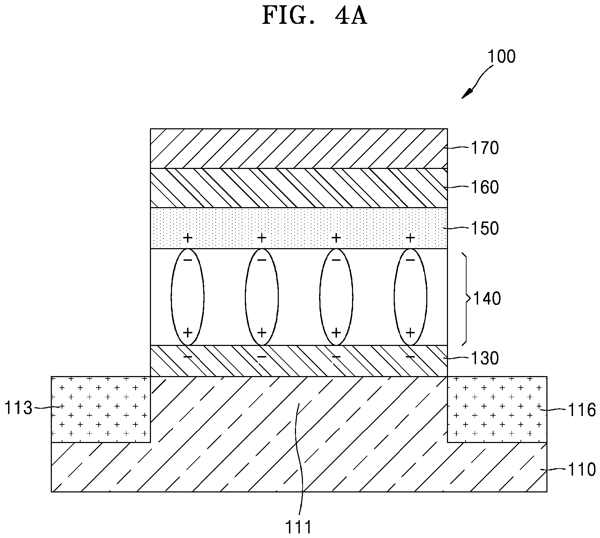

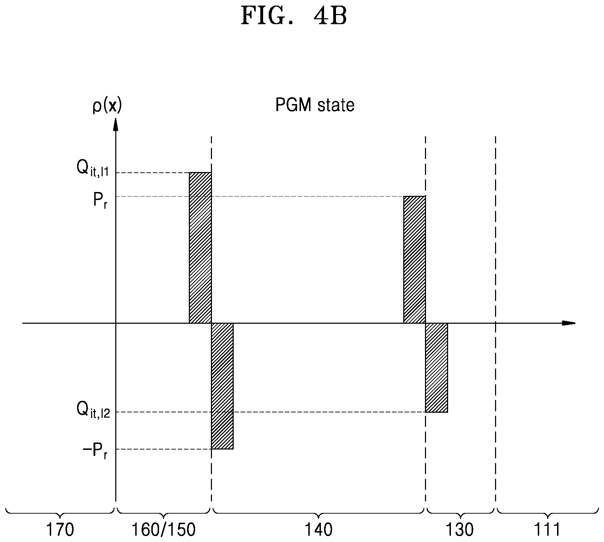

FIG. 4A is a conceptual view illustrating an electric charge distribution in a semiconductor device according to at least one embodiment when the semiconductor device is in a program state. FIG. 4B illustrates an example of an electric charge density in a semiconductor device according to at least one embodiment when the semiconductor device is in the program state.

Referring to FIG. 4A, when the semiconductor device 100 is an NMOS, in the ferroelectric layer 140, positive electric charges may move toward the channel layer 111 and negative electric charges may move toward the gate electrode 170, and the semiconductor device 100 may be in a program state. In the program state, the negative electric charges may be gathered in the second insulating layer 130, and the positive electric charges may be gathered in the charge trap layer 150. In the second insulating layer 130, the negative electric charges may be gathered at an interface with the ferroelectric layer 140, and in the charge trap layer 150, the positive electric charges may be gathered at an interface with the ferroelectric layer 140. In this program state, electrons may easily flow along the channel layer 111, and the threshold voltage of the semiconductor device 100 may be reduced.

In the graph of FIG. 4B, the vertical axis indicates an electric charge density, and the gate electrode 170, the first insulating layer 160, the charge trap layer 150, the ferroelectric layer 140, the second insulating layer 130, and the channel layer 111 in the semiconductor device 100 are located in a horizontal axis direction.

Referring to FIG. 4B, in the charge trap layer 150, an electric charge density $Q_{it,I1}$ of the positive electric charges captured at the interface with the ferroelectric layer 140 may be greater than a polarization value $P_r$ of the ferroelectric layer 140. In the second insulating layer 130, an absolute value of an electric charge density $Q_{it,I2}$ of the negative electric charges captured at the interface with the ferroelectric layer 140 may be less than the absolute value of a polarization value $-P_r$ of the ferroelectric layer 140.

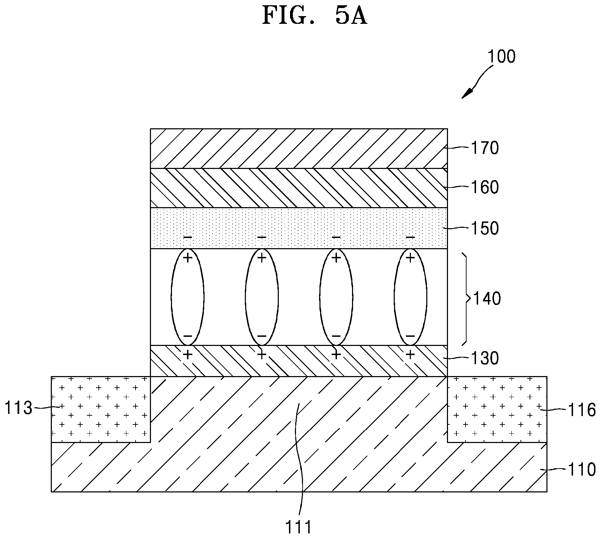

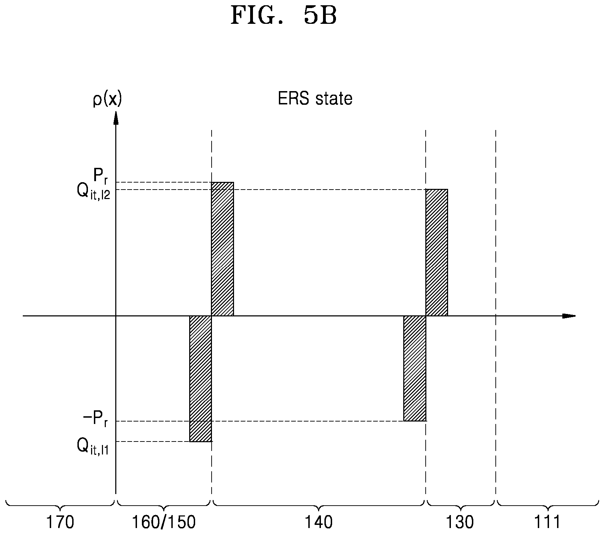

FIG. 5A is a conceptual view illustrating an electric charge distribution in a semiconductor device according to at least one embodiment when the semiconductor device is in an erase state. FIG. 5B illustrates an example of an electric charge density in a semiconductor device according to at least one embodiment when the semiconductor device is in the erase state.

Referring to FIG. 5A, when the semiconductor device 100 is an NMOS, in the ferroelectric layer 140, negative electric charges may move toward the channel layer 111 and positive electric charges may move toward the gate electrode 170, and the semiconductor device 100 may be in an erase state. The program state and the erase state may be selectively switched by applying a positive breakdown voltage or a negative breakdown voltage to the gate electrode 170 of the semiconductor device 100. In the erase state, the positive electric charges may be gathered in the second insulating layer 130, and the negative electric charges may be gathered in the charge trap layer 150. In the second insulating layer 130, the positive electric charges may be gathered at the interface with the ferroelectric layer 140, and furthermore, in the charge trap layer 150, the negative electric charges may be gathered at the interface with the ferroelectric layer 140. In this erase state, electrons may be difficult to flow along the channel layer 111, and the threshold voltage of the semiconductor device 100 may be increased.

Referring to FIG. 5B, in the charge trap layer 150, the absolute value of an electric charge density $Q_{it,I1}$ of the negative electric charges captured at the interface with the ferroelectric layer 140 may be greater than the absolute value of the polarization value $-P_r$ of the ferroelectric layer 140. In the second insulating layer 130, the electric charge density $Q_{it,I2}$ of the positive electric charges captured at the interface with the ferroelectric layer 140 may be less than the polarization value $P_r$ of the ferroelectric layer 140.

In the descriptions of FIGS. 4A to 5B, although a case of the semiconductor device 100 being an NMOS is described, the same principle may be applied to a case of the semiconductor device 100 being a PMOS. For example, in the case of the semiconductor device 100 being a PMOS, the polarizations of the electric charges described in FIGS. 4A to 5B may be opposite to each other.

As the semiconductor device 100 according to at least one embodiment includes the charge trap layer 150 that is designed to increase a charge trap amount, the memory window of the semiconductor device 100 may be increased.

The memory window of the semiconductor device 100 may be expressed by the following Equation 1.

$$MW = \frac{(\Delta P - \Delta Q_{it,I2})}{C_{Ferro}} + \frac{(\Delta Q_{it,I1} - \Delta Q_{it,I2})}{C_{I1}}$$

[Equation 1]

In Equation 1, $\Delta P$ denotes a polarization amount of the ferroelectric layer 140, $\Delta Q_{it,I2}$ denotes an amount of electric charges trapped at the interface between the ferroelectric layer 140 and the second insulating layer 130, $\Delta Q_{it,I1}$ denotes an amount of electric charges trapped at the interface between the ferroelectric layer 140 and the charge trap layer 150, $C_{Ferro}$ denotes the capacitance of the ferroelectric layer 140, and Cn denotes the capacitance by the layers between the gate electrode 170 and the ferroelectric layer 140.

As described above, the semiconductor device 100 according to at least one embodiment, which has specific structures, such as a material, a concentration, and/or the like of the charge trap layer 150 to increase $\Delta Q_{it,l1}$, may have a large memory window.

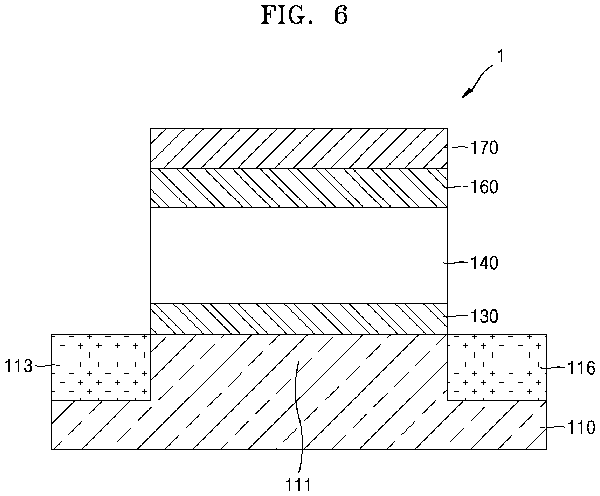

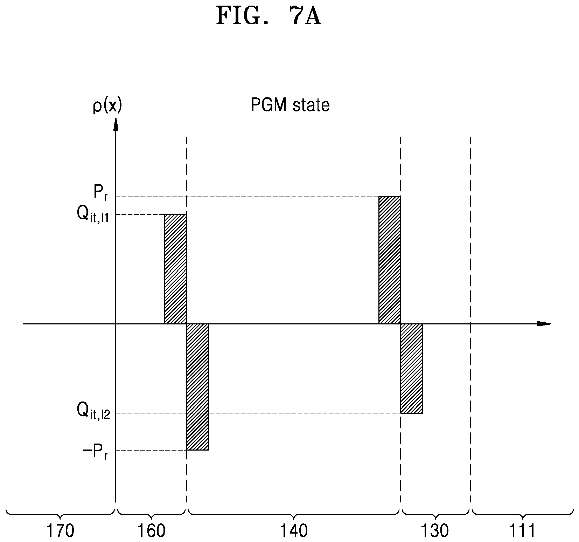

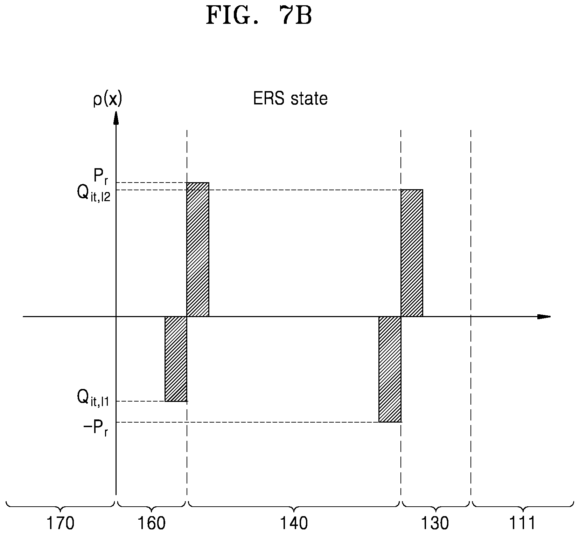

FIG. 6 is a cross-sectional view of a schematic structure of a semiconductor device 1 according to a comparative example. FIGS. 7A and 7B illustrate examples of an electric charge density in the semiconductor device 1 according to a comparative example when the semiconductor device is in a program state and an erase state.

The semiconductor device 1 according to a comparative example differs from the semiconductor device 100 of FIG. 1 in that only the first insulating layer 160 is provided between the ferroelectric layer 140 and the gate electrode 170 and the charge trap layer 150 in FIG. 1 is not included therebetween.

Referring to FIG. 7A, in a program state, in the first insulating layer 160, the electric charge density $Q_{it,l1}$ of the positive electric charges captured at the interface with the ferroelectric layer 140 is less than the polarization value $P_r$ of the ferroelectric layer 140. Comparing FIG. 7A with FIG. 4B, $Q_{it,l1}$ in FIG. 7A may have a value less than the electric charge density $Q_{it,l1}$ of the positive electric charges captured at the interface with the ferroelectric layer 140 in the charge trap layer 150 of FIG. 4B.

Referring to FIG. 7B, in an erase state, in the first insulating layer 160, the absolute value of the electric charge density, $Q_{it,l1}$ of the negative electric charges captured at the interface with the ferroelectric layer 140 may be less than the absolute value of the polarization value $-P_r$ of the ferroelectric layer 140. Comparing FIG. 7B with FIG. 5B, the absolute value of $Q_{it,l1}$ in FIG. 7B may have a value less than the absolute value of the electric charge density $Q_{it,l1}$ of the negative electric charges captured at the interface with the ferroelectric layer 140 in the charge trap layer 150 in FIG. 5B.

When Equation 1 with respect to the memory window is applied to the semiconductor device 1 according to a comparative example, this time, $\Delta Q_{it,l1}$ indicates an amount of electric charges trapped at the interface between the ferroelectric layer 140 and the first insulating layer 160. Accordingly, the semiconductor device 1 according to a comparative example may be analyzed to have a smaller memory window than that of the semiconductor device 100 according to at least one embodiment.

In other words, in the semiconductor device 100 according to at least one embodiment, as the charge trap layer 150 having the concentration gradient characteristics described above, in addition to the first insulating layer 160, is further provided between the gate electrode 170 and the ferroelectric layer 140, the memory window may be further increased.

The semiconductor device 100 described above may be applied to various electronic devices, for example, as individual memory cell in a memory device. The memory device may have a three-dimensional structure, a gate all around (GAA) structure, a vertical structure, and/or the like, for example, a vertical NAND (VNAND) structure.

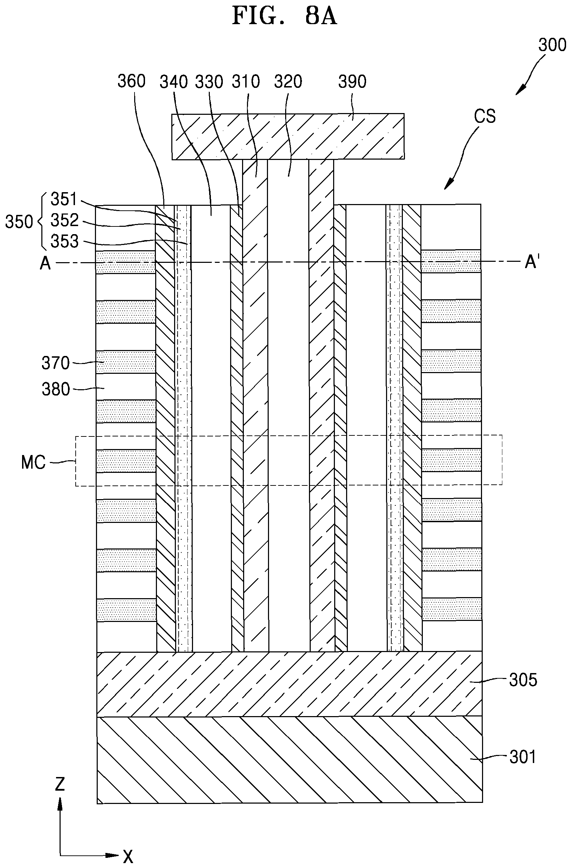

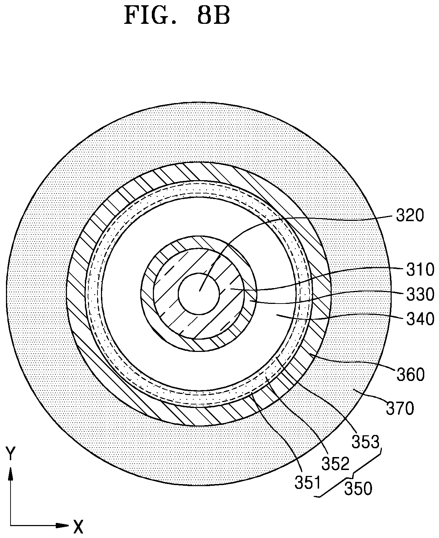

FIG. 8A is a cross-sectional view showing a schematic structure of a memory device 300 according to at least one embodiment, and FIG. 8B is a cross-sectional view of the memory device 300 of FIG. 8A taken along line A-A'.

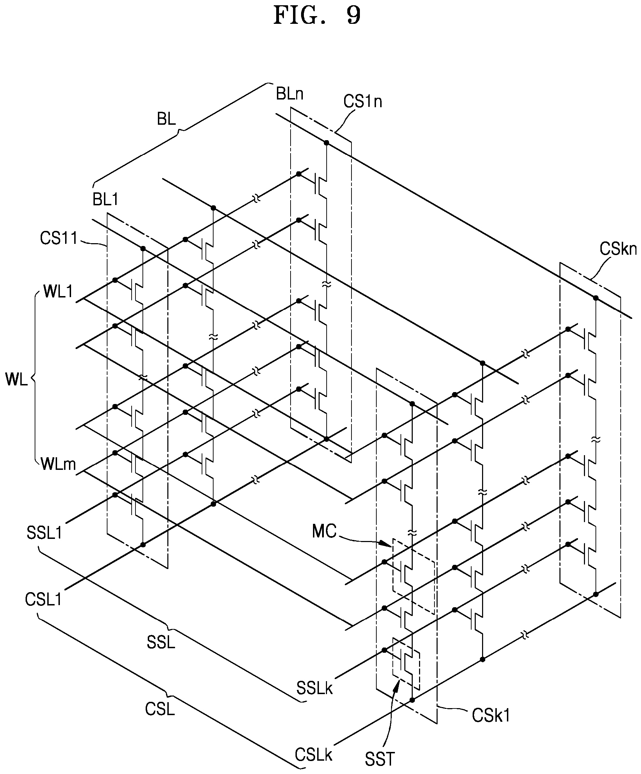

Referring to FIG. 8A, the memory device 300 may include a substrate 301 and a cell string CS formed on the substrate 301. Although one cell string CS is illustrated in the drawing, this is an example, and the memory device 300 may include a plurality of cell strings CS. For example, the cell strings CS may be arranged two-dimensionally in two directions perpendicular to a direction (Z direction) away from the substrate 301. The cell strings CS may be arranged in a matrix form of k*n, as illustrated in a circuit diagram of FIG. 9 to be described below, and may be referred to as CSij ($1 \leq i \leq k$, $1 \leq j \leq n$) according to the respective row and column positions.

The substrate 301 may be a semiconductor substrate. The substrate 301 may include a silicon material doped with first-type impurities. For example, the substrate 301 may include a silicon material doped with p-type impurities. For example, the substrate 301 may be a p-type well (e.g., a pocket p well). However, the disclosure is not limited thereto, and the substrate 301 may include various semiconductor materials.

A common source region 305 is provided on the substrate 301. The common source region 305 may be a different type from a semiconductor material included in the substrate 301, for example, an n-type. The common source region 305 may be connected to, for example, a common source line CSL that is indicated in a circuit diagram of FIG. 9.

The cell string CS may have a circuit cross-section, as illustrated in the cross-sectional view in FIG. 8B. In other words, the cell string CS may have a cylindrical shape with a central axis parallel to the Z direction. However, this is an example, and the cell string CS may have other shapes, and, for example, may be deformed into the shape of an oval column or a polygonal column.

A plurality of gate electrodes 370 may be spaced apart from each other in the axis direction of the cell string CS, for example, in the Z direction, and a spacer 380 including an insulating material may be disposed between the gate electrodes 370.

The gate electrodes 370 and the spacer 380 may have a cylinder shell shape with connected inner surfaces, and a first insulating layer 360 may be conformally formed on the inner surface. Next, a charge trap layer 350 may be conformally formed on the first insulating layer 360. The charge trap layer 350 may include a first layer 351, a second layer 352, and a third layer 353, which are respectively and substantially the same as the first layer 151, the second layer 152, and the third layer 153 described in FIGS. 1 and FIG. 2. A ferroelectric layer 340 is conformally formed on the charge trap layer 350, and then, a second insulating layer 330 and a channel layer 310 may be conformally formed.

The center portion of the cell string CS may be filled with an insulating layer 320 that is cylindrical. However, this is an example, and the insulating layer 320 may be omitted or formed in a cylinder shell shape.

The channel layer 310, the second insulating layer 330, the ferroelectric layer 340, the charge trap layer 350, the first insulating layer 360, and the gate electrodes 370 may include the materials of the channel layer 111, the second insulating layer 130, the ferroelectric layer 140, the charge trap layer 150, the first insulating layer 160, and the gate electrode 170, which are described in FIG. 1.

One end of the channel layer 310, that is, an area of the channel layer 310 located in the lowermost end of the cell string CS may be in contact with the common source region 305. As such, repeat descriptions thereof have been omitted.

A drain 390 may be provided on the cell string CS. The drain 390 may include, for example, a silicon material doped in an n-type. The other end of the channel layer 310, that is, an area of the channel layer 310 located in the uppermost end of the cell string CS may be in contact with the drain 390. The drain 390 may be connected to a bit line through contact plugs.

An area of one of the gate electrodes 370, and the first insulating layer 360, the charge trap layer 350, the ferroelectric layer 340, the second insulating layer 330, and the channel layer 310, which are in an area facing the gate electrode 370, constitute a memory cell MC.

As the memory cells MC are continuously arranged in the vertical direction (Z direction), the cell string CS is formed. The common source region 305 and the drain 390, which are connected to the opposite ends of the cell string CS, may be respectively connected to the common source line CSL and a bit line BL, which are illustrated in the circuit diagram of FIG. 9. The gate electrodes 370 are connected to a word line WL. By applying a voltage to the word line WL, the common source line CSL, and the bit line BL, program, read, and erase processes may be performed on the memory cells MC.

As described above, the ferroelectric layer 340 is a material in which a polarization value (polarization) remains semi-permanently even when a certain voltage is applied thereto and reduced back to 0 V, and the polarity (direction) of the remnant polarization may depend on the polarity (direction) of an externally applied voltage. The area of the ferroelectric layer 340 corresponding to each memory cell MC may have remnant polarization corresponding to an electric field formed in the ferroelectric layer 340 by a voltage applied to the gate electrodes 370. A conductance difference may be generated in the area of the channel layer 310 corresponding to the memory cell MC, by the polarization direction of the ferroelectric layer 340, through which information may be written or confirmed.

Furthermore, as the memory device 300 according to at least one embodiment includes the charge trap layer 350 having a certain concentration gradient in order to increase the memory window, the reliability of a memory operation may be improved.

FIG. 9 is an equivalent circuit of a memory device according to at least one embodiment. Referring to FIG. 9, the memory device may include a plurality of memory cell strings CS11 to CSkn. The memory cell strings CS 11 to CSkn are arranged two-dimensionally in a row direction and a column direction and may form rows and columns. Each cell string CSij ($1 \leq i \leq k$ and $1 \leq j \leq n$) may be connected to the bit line BL, a string selection line SSL, the word line WL, and the common source line CSL.

The cell string CSij may include the memory cells MC and a string selection transistor SST. The memory cells MC and the string selection transistor SST of each cell string CSij may be stacked in a height direction.

The rows of the cell strings CSij are respectively connected to different string selection lines SSL1 to SSLk. For example, the string selection transistors SST of the cell strings CS11 to CS1n are commonly connected to the string selection line SSL1. The string selection transistors SST of the cell strings CSk1 to CSkn are commonly connected to the string selection line SSLk.

The columns of the cell strings CSij are respectively connected to different bit lines BL1 to BLn. For example, the memory cells MC and the string selection transistors SST of the cell strings CS11 to CSk1 may be commonly connected to the bit line BL1, and the memory cells MC and the string selection transistors SST of the cell strings CS1n to CSkn may be commonly connected to the bit line BL (BLn).

The rows of the cell strings CSij may be respectively connected to different common source lines CSL1 to CSLk. For example, the string selection transistors SST of the cell strings CS11 to CS1n may be commonly connected to the common source line CSL1, and the string selection transistors SST of the cell strings CSk1 to CSkn may be commonly connected to the common source line CSLk.

The string selection transistors SST or the memory cells MC located at the same height from the substrate 301 of FIG. 8A may be commonly connected to one of word lines WL1 to WLm, and the memory cells MC located at different heights may be respectively connected to the word lines WL1 to WLm different from each other.

In the structure, write and read operations may be performed in units of rows of the memory cell strings CS11 to CSkn. For example, the memory cell strings CS11 to CSkn may be selected in units of one row by the common source line CSLS and the string selection lines SSL. The write and read operations may be performed in units of pages on the selected row of the memory cell strings CS11 to CSkn. For example, the page may be one row of the memory cells MC connected to one word line WL. In the selected row of the memory cell strings CS11 to CSkn, the memory cells MC may be selected in units of pages by the word lines WL. Each of the memory cells MC may be the same as (and/or substantially similar to) the memory cells MC of FIG. 8A, may include the semiconductor device 100, and/or may include a semiconductor device deformed therefrom.

The illustrated circuit structure is an example. For example, the number of the rows of the cell strings CSij (1≤i≤k and 1≤j≤n) may be increased or decreased. As the number of rows of the cell string CS is changed, the number of string selection lines connected to the rows of the cell string CS and the number of the cell strings CS connected to one bit line BL may be changed. As the number of rows of the cell strings CS is changed, the number of common source lines connected to the rows of the cell strings CS may also be changed.

The number of the columns of the cell strings CSij may be increased or decreased. As the number of the columns of the cell strings CSij is changed, the number of the bit lines BL connected to the columns of the cell strings CSij and the number of the cell strings CSij connected to one string selection line may be also be changed.

The heights of the cell strings CSij may be increased or decreased. For example, the number of the memory cells MC stacked on each of the cell strings CSij may be increased or decreased. As the number of the memory cells MC stacked on each of the cell strings CSij is changed, the number of the word lines WL may also be changed. For example, the string selection transistor provided to each of the cell strings CSij may be increased. As the number of the string selection transistors provided to each of the cell strings CSij is changed, the number of the string selection lines or the common source lines may be changed. As the number of the string selection transistors is increased, the string selection transistors may be stacked in the same form as the memory cells MC.

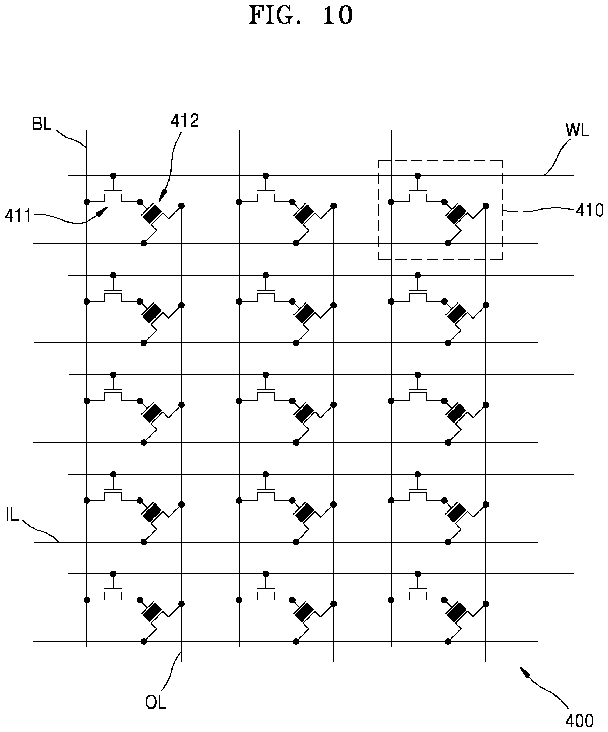

FIG. 10 is a schematic circuit diagram of a neural network device 400 according to at least one embodiment. Referring to FIG. 10, the neural network device 400 according to at least one embodiment may include an array of a plurality of synapse devices 410 that are arranged two-dimensionally. Each of the synapse devices 410 may include an access transistor 411 and a ferroelectric field-effect transistor 412. The ferroelectric field-effect transistor 412 may be the semiconductor device 100 described in FIGS. 1 to 5B, or a semiconductor device deformed therefrom. The access transistor 411 may function as a selection device to turn the synapse devices 410 on/off

The neural network device 400 may also include a plurality of word lines WL, a plurality of bit lines BL, a plurality of input lines IL, and a plurality of output lines OL. In the access transistor 411, a gate may be electrically connected to any one word line of the word lines WL, a source may be electrically connected to any one bit line of the bit lines BL, and a drain may be electrically connected to a gate of the ferroelectric field-effect transistor 412. Furthermore, in the ferroelectric field-effect transistor 412, a source may be electrically connected to any one input line of the input lines IL, and a drain may be electrically connected to any one output line of the output lines OL.

In a training operation of the neural network device 400, the access transistor 411 is individually turned on through an individual word line WL, and a program pulse may be applied to a gate of the ferroelectric field-effect transistor 412 through the bit line BL. A signal of training data may be applied through the input lines IL. A weight may be stored in each of the ferroelectric field-effect transistor 412 through the process.

During the inference operation of the neural network device 400, all the access transistors 411 are turned on through all the word lines WL, and a read voltage Vread may be applied through the bit line BL. Then, the sum of currents from the synapse devices 410 connected in parallel to the output lines OL may flow in each of the output lines OL. As an output circuit is connected to the output lines OL, a current flowing in each of the output lines OL may be converted into a digital signal.

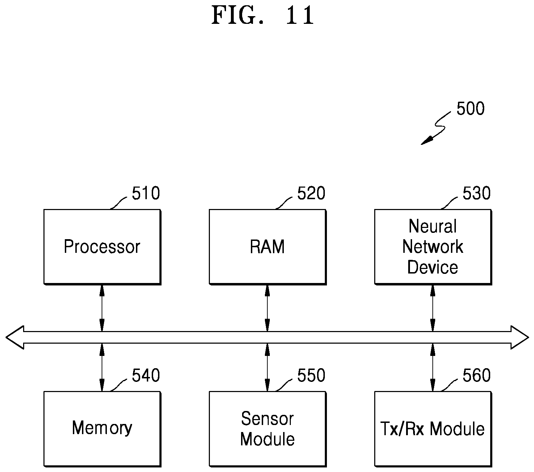

FIG. 11 is a schematic block diagram of an electronic device 500 including a neural network device according to at least one embodiment. Referring to FIG. 11, the electronic device 500 may extract valid information by analyzing input data in real time based on a neural network and make situational determination based on the extracted information, or may control components of a device on which the electronic device 500 is mounted. For example, the electronic device 500 may be applied to robot devices, such as drones, advanced drivers assistance systems (ADAS), and/or the like, smart TVs, smartphones, medical devices, mobile devices, image display devices, measuring devices, IoT devices, and/or the like, and may be additionally mounted at least one of various types of devices.

The electronic device 500 may include a processor 510, random access memory (RAM) 520, a neural network device 530, a memory 540, a sensor module 550, and a communication module 560. The electronic device 500 may further include an input/output module, a security module, a power control device, and/or the like. Some of hardware components of the electronic device 500 may be mounted on at least one semiconductor chip.

The processor 510 controls the overall operation of the electronic device 500. The processor 510 may include one processor core (single core) or a plurality of processor cores (multicore). The processor 510 may process or execute programs and/or data stored in the memory 540. In some embodiments, the processor 510 may control functions of the neural network device 530 by executing programs stored in the memory 540. The processor 510 may be implemented by a central processing unit (CPU), a graphics processing unit (GPU), an application processor (AP), and/or the like.

The RAM 520 may temporarily store programs, data, or instructions. For example, the programs and/or data stored in the memory 540 may be temporarily stored in the RAM 520 under the control of the processor 510 or according to booting code. The RAM 520 may be implemented by memory, such as dynamic RAM (DRAM), static RAM (SRAM), and/or the like.

The neural network device 530 may be configured to perform an operation of a neural network based on the received input data, and generate an information signal based on a result of the performance of the operation. The neural network may include a convolution neural network (CNN), a recurrent neural network (RNN), a feedforward neural network (FNN), a long short-term memory (LSTM), a stacked neural network (SNN), a state-space dynamic neural network (SSDNN), a deep belief network (DBN), a restricted Boltzmann machine (RBM), and/or the like, but the disclosure is not limited thereto. The neural network device 530 may be a neural network dedicated hardware accelerator itself or a device including the same. The neural network device 530 may perform not only an operation of a neural network, but also a read or write operation. The neural network device 530 may correspond to a neural network device 400 according to at least one embodiment which is illustrated in FIG. 10.

The information signal may include one of various types of recognition signals, such as a voice recognition signal, an object recognition signal, an image recognition signal, a biometric information recognition signal, and/or the like. For example, the neural network device 530 may receive frame data included in a video stream, as input data, and generate, from the frame data, a recognition signal for an object included in the image represented by the frame data. However, the disclosure is not limited thereto, and based on the type or function of a device on which the electronic device 500 is mounted, the neural network device 530 may receive various types of input data and generate a recognition signal according to the input data.

The neural network device 530 may be configured to perform, for example, a machine learning model, such as linear regression, logistic regression, statistical clustering, Bayesian classification, decision trees, principal component analysis, and/or an expert system, and/or a machine learning model, such as ensemble technique, such as random forest, and/or the like. These machine learning models may be used to provide various services, such as image classification services, user authentication services based on biometric information or biological data, ADAS, voice assistant services, automatic speech recognition (ASR) services, and/or the like.

The memory 540, which is a place for storing data, may store operating system (OS), various programs, and various pieces of data. In at least one embodiment, the memory 540 may store intermediate results generated in operation processes of the neural network device 530.

The memory 540 may include DRAM, but the disclosure is not limited thereto. The memory 540 may include at least one of volatile memory or non-volatile memory. The non-volatile memory may include read only memory (ROM), programmable ROM (PROM), electrically programmable ROM (EPROM), electrically erasable and programmable ROM (EEPROM), flash memory, phase-change RAM (PRAM), magnetic RAM (MRAM), resistive RAM (RRAM), ferroelectric RAM (FRAM), and/or the like. The volatile memory may include dynamic RAM (DRAM), static RAM (SRAM), synchronous DRAM (SDRAM), phase-change RAM (PRAM), magnetic RAM (MRAM), resistive RAM (RRAM), ferroelectric RAM (FeRAM), and/or the like. In at least one embodiment, the memory 540 may include at least one of a hard disk drive (HDD), a solid-state drive (SSD), compact flash (CFs), secure digital (SD), micro secure digital (Micro-SD), mini secure digital (Mini-SD), or Memory Stick.

The sensor module 550 may collect information around a device on which the electronic device 500 is mounted. The sensor module 550 may sense or receive a signal from the outside of the electronic device 500 (e.g., an image signal, a voice signal, a magnetic signal, a biological signal, a touch signal, and/or the like), and convert the sensed or received signal into data. To this end, the sensor module 550 may include at least one of various types of sensing devices, such as a microphone, an imaging device, an image sensor, a light detection and ranging (LIDAR) sensor, an ultrasound sensor, an infrared sensor, a biosensor, a touch sensor, and/or the like.

The sensor module 550 may provide converted data, as input data, to the neural network device 530. For example, the sensor module 550 may include an image sensor, and may generate a video stream by photographing the external environment of the electronic device 500, and provide successive data frames of the video stream, as input data, to the neural network device 530. However, the disclosure is not limited thereto, and the sensor module 550 may provide various types of data to the neural network device 530.

The communication module 560 may include various wired or wireless interfaces for communication with an external device. For example, the communication module 560 may include a communication interface capable of accessing a mobile cellular network and/or the like, such as a wired local area network (LAN), a wireless local area network (WLAN) such as wireless fidelity (Wi-Fi), a wireless personal area network (WPAN) such as Bluetooth, a wireless universal serial bus (USB), Zigbee, near field communication (NFC), radio-frequency identification (RFID), power line communication (PLC), or '3rd generation (3G)' 4th generation (4G), long term evolution (LTE), and/or the like.

The semiconductor device described above may operate as a field effect transistor with an increased memory window.

The semiconductor device described above may have improved operation reliability and may be used as a memory cell of a memory device.

It should be understood that the semiconductor device described above and an electronic device including the same described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

**Claims**

1. A semiconductor device comprising:

   a channel layer comprising a semiconductor material;
   a gate electrode spaced apart from the channel layer in a first direction;
   a ferroelectric layer between the channel layer and the gate electrode, the ferroelectric layer comprising a ferroelectric material;
   a first insulating layer between the ferroelectric layer and the gate electrode;
   a charge trap layer between the ferroelectric layer and the first insulating layer, the charge trap layer comprising a compound including a first element; and
   a second insulating layer between the channel layer and the ferroelectric layer,
   wherein the charge trap layer comprises a third layer, a second layer, and a first layer, sequentially stacked in the first direction, and each of the first layer, the second layer, and the third layer have a different concentration of the first element, and
   wherein a highest value in a concentration gradient in the first layer is a first concentration value, a lowest value in a concentration gradient in the second layer is a second concentration value, a highest value in a concentration gradient in the third layer is a third concentration value, and the second concentration value is lower than the first concentration value and the third concentration value.

2. The semiconductor device of claim 1, wherein the first concentration value is higher than the third concentration value.

3. The semiconductor device of claim 1 or 2, wherein a thickness of the second layer is 50% or more of a total thickness of the charge trap layer.

4. The semiconductor device of any preceding claim, wherein, in the concentration gradient of the second layer, a length in the first direction of an area having a concentration lower than the third concentration value is 60% or more of a thickness of the second layer.

5. The semiconductor device of any preceding claim, wherein a thickness of the second layer is greater than a thickness of the first layer and a thickness of the third layer.

6. The semiconductor device of any preceding claim, wherein a thickness of the third layer is 1% or more of a total thickness of the charge trap layer.

7. The semiconductor device of any preceding claim, wherein a thickness of the third layer is greater than a thickness of the first layer.

8. The semiconductor device of any preceding claim, wherein the charge trap layer further comprises nitrogen.

9. The semiconductor device of any preceding claim, wherein the first layer, the second layer, and the third layer each independently comprise a compound represented by MN, wherein M denotes the first element and includes one or more elements selected from the group consisting of Al, Ga, Ge, Si, C, In, Y, Sc, and Zr, and N denotes nitrogen.

10. The semiconductor device of claim 8 or 9, wherein the first layer, the second layer, and the third layer each independently comprise the nitride of the first element, in which a nitrogen content is less than stoichiometry.

11. The semiconductor device of claim 10, wherein the first layer, the second layer, and the third layer each independently comprise $Si_3N_{4-x}$, where $0<x\leq2$.

12. The semiconductor device of any preceding claim, wherein the second insulating layer comprises an oxide of a material of the channel layer.

13. The semiconductor device of any preceding claim, wherein the ferroelectric material of the ferroelectric layer comprises a hafnium oxide-based material, and optionally wherein the ferroelectric material further comprises at least one of Zr, La, Al, Si, Y, B, or Sc as a dopant.

14. The semiconductor device of claim 1, the first element includes one or more elements selected from the group consisting of Al, Ga, Ge, Si, C, in, Y, Sc, and Zr.

15. An electronic device comprising:

a semiconductor substrate; and
a plurality of memory cells stacked on the semiconductor substrate,
wherein each of the plurality of memory cells comprises a semiconductor device according to any preceding claim, and optionally further comprising:
a spacer, including an insulating material, between the plurality of memory cells such that the spacer is between adjacent gate electrodes, and further optionally wherein the adjacent gate electrodes and the spacer have shell shapes with connected inner surfaces.

# FIG. 1

FIG. 2

FIG. 3

# FIG. 4A

FIG. 4B

# FIG. 5A

100

170

160

150

140

130

113

116

110

111

# FIG. 5B

## FIG. 6

1

170

160

140

130

113

116

110

111

# FIG. 7A

# FIG. 7B

# FIG. 8A

FIG. 8B

# FIG. 9

# FIG. 10

# FIG. 11

500

| Processor 510 | RAM 520 | Neural Network Device 530 |

| Memory 540 | Sensor Module 550 | Tx/Rx Module 560 |

Europäisches
Patentamt

European
Patent Office

Office européen
des brevets

# EUROPEAN SEARCH REPORT

**Application Number**

EP 24 21 7417

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | KR 2023 0158991 A (KOREA ADVANCED INST SCI & TECH [KR]) 21 November 2023 (2023-11-21) | 1-10, 12-15 | INV. H10B51/10 |
| A | * paragraph [0039] - paragraph [0063]; figure 3 * <br> * paragraph [0001] - paragraph [0007]; figure 1 * <br> * paragraph [0015] * <br> * paragraph [0032] * <br> ----- | 11 | H10B51/20 <br> H10B51/30 <br> H10D30/01 <br> H10D30/69 <br> H10D64/01 <br> H10D64/68 |
| Y | EP 0 096 062 B1 (NCR CO [US]) 4 June 1986 (1986-06-04) | 1-10, 12-15 | |
| A | * figures 1, 5 and the associated description * <br> * column 12, line 43 - line 53 * <br> * column 12, line 2 - line 9 * <br> ----- | 11 | |
| A | US 9 502 521 B2 (GANGULY UDAYAN [US]; OLSEN CHRISTOPHER S [US] ET AL.) 22 November 2016 (2016-11-22) * column 7, line 44 - column 8, line 5; figures 1, 2 * <br> ----- | 8-11 | |

**TECHNICAL FIELDS SEARCHED (IPC)**

H10B
H10D

The present search report has been drawn up for all claims

| Place of search | Date of completion of the search | Examiner |
|---|---|---|
| Munich | 7 April 2025 | Nesso, Stefano |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 7417

This annex lists the patent family members relating to the patent documents cited in the above-mentioned European search report.
The members are as contained in the European Patent Office EDP file on
The European Patent Office is in no way liable for these particulars which are merely given for the purpose of information.

07-04-2025

| Patent document cited in search report | | Publication date | Patent family member(s) | | Publication date |
|---|---|---|---|---|---|
| KR 20230158991 | A | 21-11-2023 | NONE | | |
| EP 0096062 | B1 | 04-06-1986 | CA | 1188419 A | 04-06-1985 |
| | | | DE | 96062 T1 | 26-04-1984 |
| | | | EP | 0096062 A1 | 21-12-1983 |
| | | | JP | H0548631 B2 | 22-07-1993 |
| | | | JP | S58502126 A | 08-12-1983 |
| | | | WO | 8302199 A1 | 23-06-1983 |
| US 9502521 | B2 | 22-11-2016 | US | 2011101442 A1 | 05-05-2011 |
| | | | US | 2011281429 A1 | 17-11-2011 |

EPO FORM P0459

For more details about this annex : see Official Journal of the European Patent Office, No. 12/82